# EUROPEAN PATENT SPECIFICATION

(11) **EP 0 994 328 B1**
(45) Date of publication and mention of the grant of the patent: **10.10.2007**
(21) Application number: 99202939.7
(22) Date of filing: 09.09.1999
(51) Int. Cl.: G01B 11/24, G01N 21/88, G01N 21/95, G01R 31/316, G01N 21/956

(54) **Electronic parts checking apparatus**
Prüfapparat für elektronische Bauteile
Appareil de contrôle pour composants électroniques

(30) Priority: 13.10.1998 JP 28991398
(43) Date of publication of application: 19.04.2000
(73) Proprietor: Yamagata Casio Co., Ltd., Higashine-city, Yamagata 999-3701 (JP)
(72) Inventor: Seino, Hideyuki, Yamagata Casio Co., Ltd., Yamagata 999-3701 (JP); Takahashi, Takayuki, Yamagata Casio Co., Ltd., Yamagata 999-3701 (JP)
(74) Representative: Lucas, Brian Ronald

(56) References cited:
- EP-A- 0 638 801
- US-A- 5 302 836
- US-A- 5 761 337

## Description

### Background of the Invention

### Field of the Invention

The present invention relates to an electronic parts checking apparatus, and more specifically to an electronic parts checking apparatus for appropriately checking the acceptability of a ball in BGA electronic parts (see e.g. US-A-5 302 836).

### Description of the Related Art

In response to a strong demand for a smaller and a higher-speed electronic devices, the integration level of an LSI for electronic parts mounted on a printed substrate has become higher and higher. The higher the integration level of the LSI of the electronic parts (chips) becomes, the larger the number of wiring terminals from the chips becomes. That is, recently there have been more electronic parts in which the number of wiring terminals is increased by making lead wires projecting from four sides of a chip than the electronic parts in which lead wires project from two sides of a chip. In addition, there has been an increasing number of electronic parts (BGA electronic parts) in which a hemispheric wiring terminal called a bump is formed as covering the bottom of the chip.

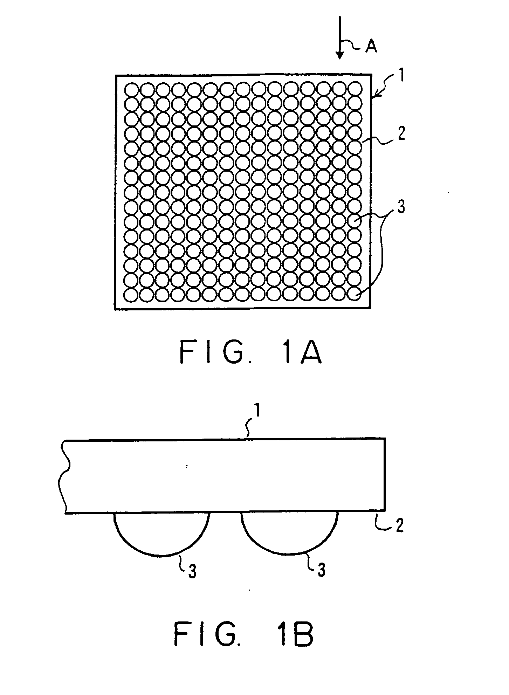

FIG. 1A shows a plan view of the panel (bottom) on which bumps are arranged for the BGA electronic parts. FIG. 1B is an enlarge view from the arrow A. As shown in FIGS. 1A and 1B, bumps 3 are arranged as covering a bottom 2 of a BGA electronic parts 1. Normally, the bumps 3 are arranged by applying a hemispheric solder ball to an Ni or Al base. The BGA electronic parts 1 are held as adsorbed to an adsorption nozzle at the head of the mounting head of a parts mounting device, and transmitted to the attachment position of the printed substrate. After the wiring terminal of the printed substrate and the bumps of the BGA electronic parts are mounted as matching each other, the solder paste is solidified and fixed to a predetermined position on the printed substrate.

Thus, by providing the bottom of the chip with the bumps, the number of wiring terminals can be easily increased, and the operations of mounting the bumps onto the printed substrate can also be easily realized, thereby furthermore increasing the demand for the technology.

If any electronic parts, not limited to the BGA electronic parts, miss any wiring terminal or include any wiring terminals defective in shape, etc., and if these electronic parts are mounted as is onto a printed substrate, then a defective wiring connection arises and the entire printed substrate becomes defective.

As a result, other parts mounted together onto the printed substrate are completely discarded, thereby resulting in a considerably uneconomical process. In addition, there also arises the problem that the working time taken to process a printed substrate is wasted, thereby deteriorating the performance.

To avoid the above described problems, it is necessary to quickly remove defective parts when they are detected by preliminarily checking whether or not there are defects on the wiring terminals in electronic parts.

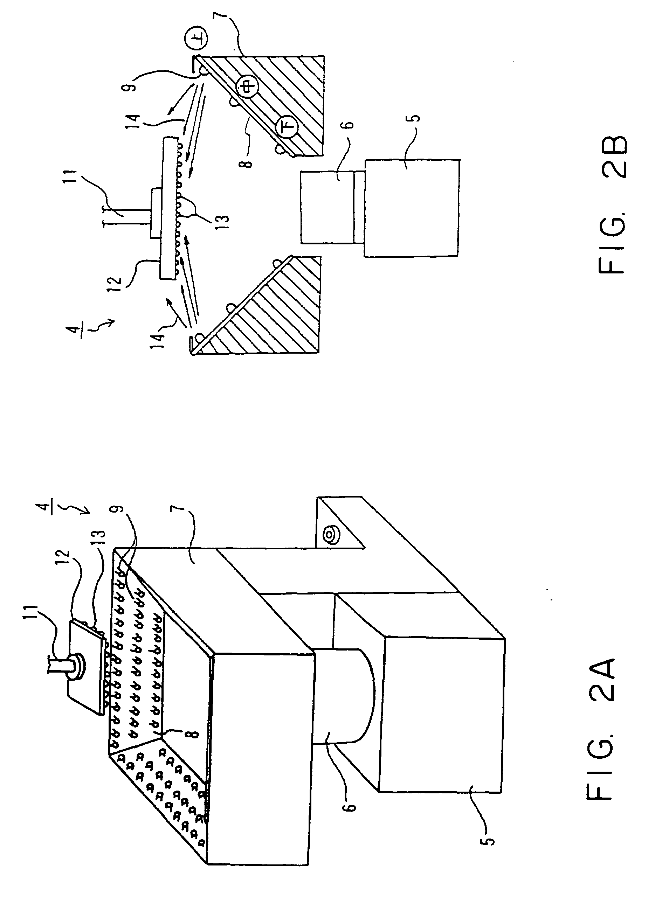

FIG. 2A is an oblique view showing an example of a conventional electronic parts checking apparatus. FIG. 2B is a side sectional view. As shown in FIGS. 2A and 2B, an electronic parts checking apparatus 4 is provided with a square-framed lighting unit 7 above a lens 6 of a shooting camera 5. The lighting unit 7 contains four plates forming slopes each spreading upward. These four slopes 8 are provided with a number of light sources 9 in the upper, intermediate, and lower rows of each of the four slopes 8.

These light sources 9 in the upper, intermediate, and lower rows are used depending on the types of the electronic parts to be lighted. In the examples shown in FIGS. 2A and 2B, a part 12 held by a parts holder 11 is a BGA electronic part having bumps 13 on the bottom, and the light sources 9 in the upper row are turned on as indicated by an arrow 14 as shown in FIG. 2B.

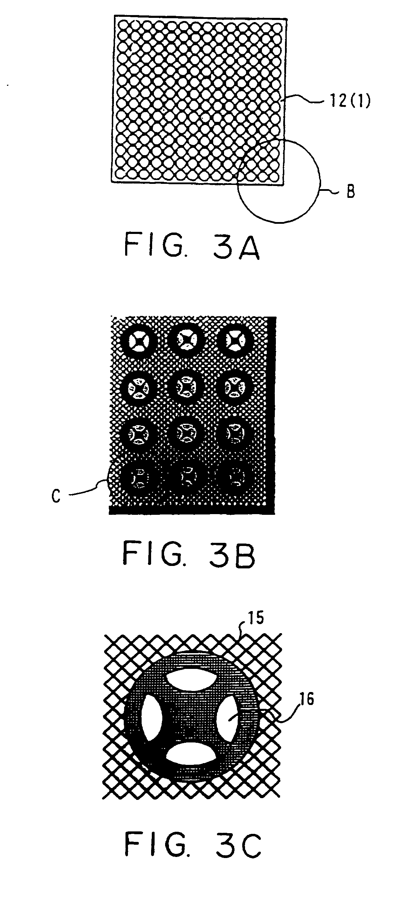

FIG. 3A shows the surface of the electronic parts 12 (the BGA electronic parts 1 shown in FIGS. 1A and 1B) provided with bumps, lighted by the above described lighting unit 7, and shot by the shooting camera 5. FIG. 3B is an enlarged view of the pattern of the part enclosed by the circle B shown in FIG. 3A. FIG. 3C is a further enlarged vies of a ball portion enclosed by the circle C shown in FIG. 3B, and is an image for use in recognizing the acceptability of a ball to be checked. In the conventional bump recognizing method, a portion shot in white is discriminated using a predetermined tolerance value for the ratio of the area of the portion to the total area of the bump, or using a predetermined tolerance value for the diameter of a bump after measuring the dimension of the outline of the white portion. Otherwise, it is discriminated in the pattern matching method using the matching ratio between the white portion and a predetermined form.

As shown in FIG. 3C, the image for use in recognizing the acceptability of a ball to be checked is only shown as a bright image 16 of a symmetrical cross formed by four forms like Rugby balls with a background 15 indicated by a dark network. It is determined that the parts are defective if the portions shown as the bright images 16 like balls are deformed or missing. Since the portion between the balls is the same as the background 15, the acceptability of the portion cannot be determined.

If the acceptability is determined using the shot image, the image is turned by 45° to check all balls again. That is, it takes double time, thereby outstandingly deteriorating the performance of the checking process.

In addition, if the acceptability is checked on the positions of the four bright images 16 shown in FIG. 3C without turning the images at all, that is, if it is checked at the probability of about 1/2, then it may be a little more useful than no checks, but it is finally determined after mounting the BGA electronic parts onto the printed substrate by actually flowing an electric current for check.

However, in this method, BGA electronic parts having defective balls have a chance to be accidentally mounted onto a printed substrate, thereby failing to obtain high yields in the production of electronic substrates, and failing to solve the problem of uneconomical operations with defects or the problem of the waste of time in the mounting process.

### Disclosure of the Invention

The first object of the present invention is to provide a electronic parts checking apparatus for correctly and quickly determining the acceptability of the balls provided on BGA electronic parts to solve the above described problems. To attain this, the electronic parts checking apparatus according to the present invention includes a lighting unit having a plurality of light sources provided along the predetermined circumference to light and encompass as a ring an object to be lighted; a parts holder for holding BGA electronic parts at the position where the lighting unit can light the ball arrangement surface of the BGA electronic parts at a small angle of incidence; and a shooting unit for shooting a ball arrangement surface lighted by the lighting unit of the BGA electronic parts held by the parts holder. The above described lighting unit, holding unit, and shooting unit are arranged such that the balls of the BGA electronic parts can form a regular-ring-shaped bright image.

This electronic parts checking apparatus further includes a storage unit for storing a predetermined and preliminarily input parameter related to the above described balls of the BGA electronic parts; and a determination unit for determining the acceptability of the ball of the BGA electronic parts based on the predetermined parameter stored in the storage unit, and the data in a predetermined direction obtained from a bright image of the ball of the BGA electronic parts shot by the shooting unit. The relative position between the holding unit and the lighting unit is set such that the angle of incidence from the light source to the ball arrangement surface of the BGA electronic parts held by the holding unit is 10° ± 5°.

Thus, when the ball on the arrangement surface of the BGA electronic parts is normal, a bright image of a regular ring having an even thickness can be recognized, thereby correctly determining the acceptability of the ball.

### Brief Description of the Drawings

FIG. 1A is a plan view of the bump arrangement surface (bottom) of the BGA electronic parts;
FIG. 1B is an enlarged view of the portion indicated by the arrow A shown in FIG. 1A;
FIG. 2A is an oblique view of an example of a conventional electronic parts checking apparatus;
FIG. 2B is a side sectional view of a conventional electronic parts checking apparatus;
FIG. 3A shows the bump arrangement surface of the BGA electronic parts shot by a conventional shooting camera using a lighting unit;
FIG. 3B is an enlarged view of the pattern of the portion encompassed by the circle B shown in FIG. 3A;
FIG. 3C is a ball acceptability recognition image obtained by further enlarging the portion encompassed by the circle C shown in FIG. 3B;
FIG. 4A is a side sectional view of the electronic parts checking apparatus according to an embodiment of the present invention;
FIG. 4B is an oblique view of the electronic parts checking apparatus;
FIG. 5A is an enlarged side view of a portion of the BGA electronic parts;
FIG. 5B shows a bright image of an acceptable bump of the BGA electronic parts shot by the electronic parts checking apparatus;
FIGS. 5C and 5D show bright images of defective bumps;
FIG. 6A shows the positional relationship between the parts holder and the lighting unit according to an embodiment of the present invention;
FIG. 6B shows an image of a bump when the positional relationship is acceptable;
FIGS. 6C and 6D show an image when the positional relationship is not acceptable;
FIGS. 7A and 7B show the reason for a portion lacking in the ring of a bright image of a normal bump;
FIGS. 8A and 8B show a bright image measuring method in the parts acceptability determining process; and
FIG. 9 is a flowchart of the operation of the parts acceptability determining process by the parts determination unit.

### Detailed Explanation

Described below are the best modes for embodying the present invention.

The embodiments of the present invention are described below by referring to the attached drawings.

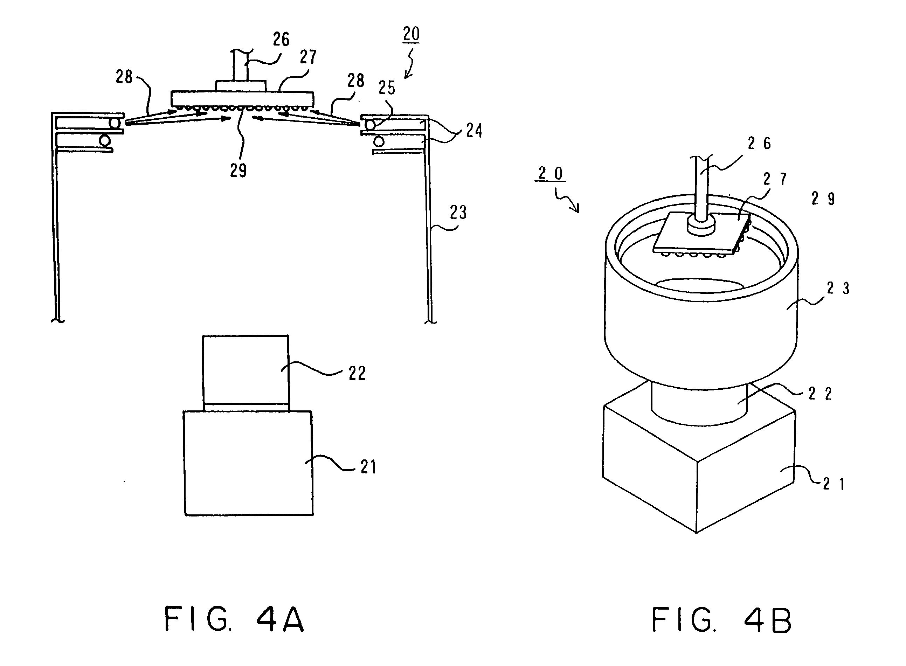

FIG. 4A is a side sectional view of the electronic parts checking apparatus according to an embodiment of the present invention, and FIG. 4B is an oblique view of the electronic parts checking apparatus. As shown in FIGS. 4A and 4B, an electronic parts checking apparatus 20 is provided with, above a lens 22 of a shooting camera 21, a cylindrical lighting unit 23 having upward and downward openings. The downward opening encompasses the lens 22 of the shooting camera 21.

The upward opening of the lighting unit 23 is provided with a plurality of (two in the example shown in FIG. 4A) upper and lower ring-shaped light source cabinets 24 each being formed as a plurality of (three in the example shown in FIG. 4A) flanges projecting inward. A light source 25 comprising a plurality of LED(light-emitting-diode)s is provided at the tip of each of the light source cabinets 24, and has a ring-shaped illumination unit. Each of the upper and lower ring-shaped illumination units is used depending on the type of electronic parts to be lighted.

Close to the upward opening of the lighting unit 23, a parts holder 26 (normally a work head of a parts mounting device) keeps on standby for a shooting process by holding a part (BGA electronic part in the example shown in FIGS. 4A and 4B) 27 at the tip of an adsorption nozzle of the parts holder 26. When the part 27 is a BGA electronic part, the light source 25 of the upper light source cabinet 24 is lighted as indicated by an illumination light 28 shown in FIG. 4A.

The positional relationship between the parts holder 26 and the lighting unit 23 is set such that the bottom on which bumps 29 of the BGA electronic parts 27 lighted by the illumination light 28 of the lighting unit 23 are arranged can be lighted at smaller degrees.

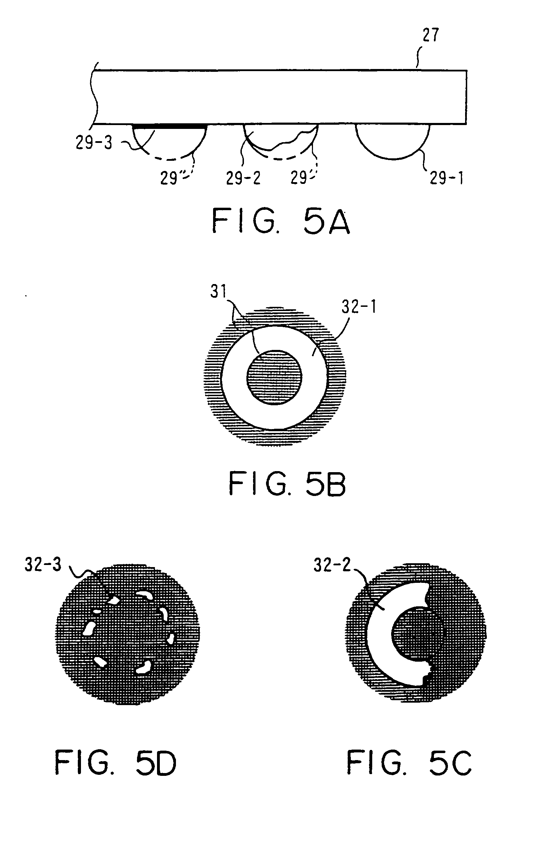

FIG. 5A is an enlarged side view of a portion of the BGA electronic parts. FIG. 5B shows a bright image of a normal bump of the BGA electronic parts 27 lighted by the lighting unit 23 of the electronic parts checking apparatus 20, and shot by the shooting camera 21. FIGS. 5C and 5D show bright images of defective bumps.

As shown in FIG. 5A, assuming that the BGA electronic parts 27 contains normal bumps 29-1 and defective bumps 29-2, a shot image of a normal bump 29-1 is as dark at the portions near the foot and the central portion of the hemisphere bump as the background, but the portion between them forms a ring-shaped bright image 32-1. The bright image 32-1 forming a right ring corresponding to the normal bump 29-1 is obtained by adjusting the positional relationship between the parts holder 26 and the lighting unit 23, and the arrangement of the shooting camera 21.

On the other hand, as shown in FIG. 5A, when the defective bump 29-2 misses about a half of a regular hemisphere 29', it is shot as a bright image 32-2 missing a half of a regular ring-shaped bright image as shown in FIG. 5C. In addition, as shown in FIG. 5D, when a defective bump 29-3 misses almost all of a regular hemisphere 29'', it is shot as a partially bright image 32-3 as a portion of the solder for the missing bump.

The above described bright images 32 (32-1, 32-2, and 32-3) are formed by reflecting the light on a normal surface of the intermediate portion of the bump. Therefore, an irregular ring-shaped bright image different from the shape shown in FIG. 5C or 5D can be formed from a defective shape of any type not limited to the defective shapes of the defective bumps 29-2 and 29-3.

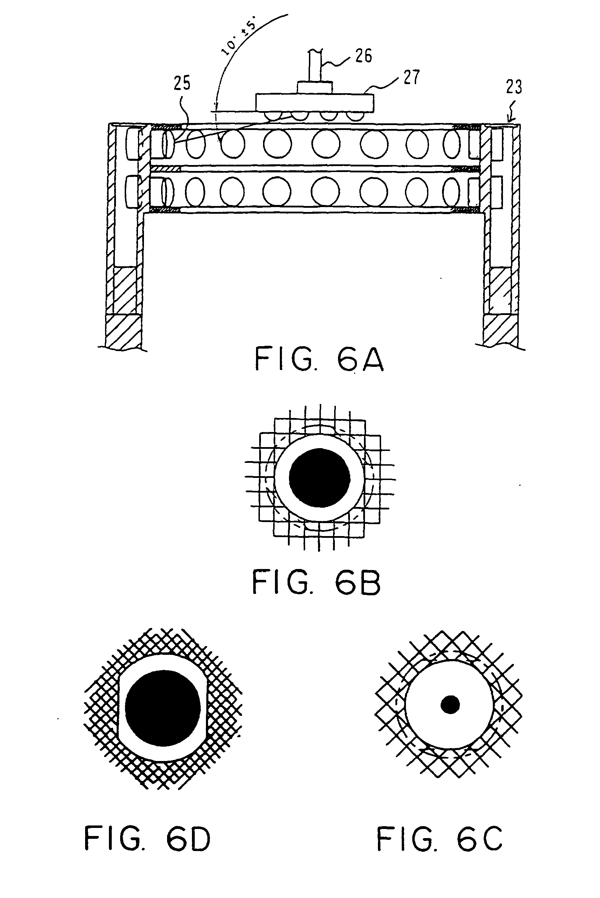

FIG. 6A shows the positional relationship between the parts holder 26 and the lighting unit 23 to obtain a regular ring-shaped bright image having an even thickness as shown in FIG. 5B corresponding to the normal bump 29-1 shown in FIG. 5A according to an embodiment of the present invention. The angle of incidence from the light source 25 to the bump arrangement surface of the BGA electronic parts 27 held by the parts holder 26 is 10° ± 5° as shown in FIG. A6.

Thus, bright images forming regular rings having even thickness as shown in FIG. 6B (same as FIG. 5B) can be obtained. If the angle of incidence is larger than 10° ± 5°, then the thickness of the ring of the bright image becomes too large as shown in FIG. 6C. Even if there is defective unevenness on the surface of the bumps, the above described bright image absorbs the shadow, that is, the defect, thereby disabling correct discrimination to be made.

If the angle of incidence is smaller than 10° ± 5°, then the thickness of the ring of the bright image becomes uneven by a missing portion in the ring of the bright image even if the bumps are normal as shown in FIG. 6D, thereby disabling correct discrimination to be made.

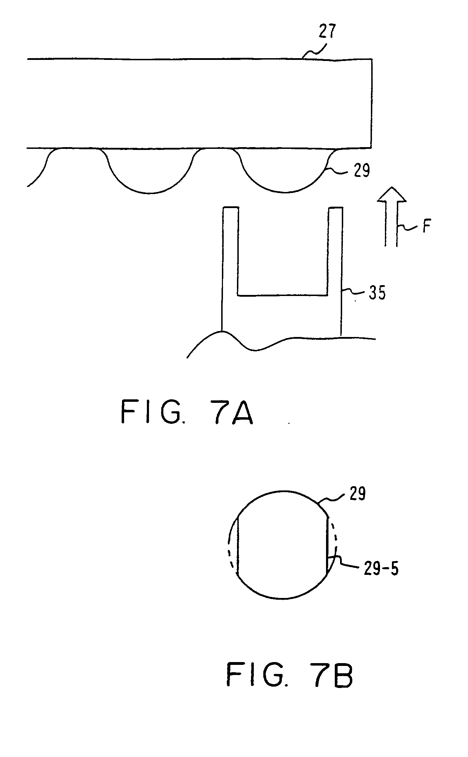

FIGS. 7A and 7B show the reason for the portions missing in the rings of the bright images when the angle of incidence is smaller than 10° ± 5° even if the bumps are normal. When BGA electronic parts 27 shown in FIG. 7A are completed in the electronic parts manufactories, the bumps are supplied with electric power to confirm that the circuit in the chip is correctly connected to a terminal (bump) (a circuit test), and then a connection check is made. In this checking process, the circuit test is conducted for each bump with a two-legged probe contact 35 inserted into the base of the bump 29 as indicated by the arrow F.

At this time, as shown in the plan view of the bump shown in FIG. 7B, a crushed portion 29-5 is detected at the base of the bump 29. The crushed portion itself does not deteriorate the quality of the bump 29 (the function for connection to the circuit of the printed substrate). However, when the shapes of the bumps are checked, their images show the influence as shown in FIG. 6D. The positional relationship between a parts holder 26 and the lighting unit 23 is set such that the crushed portion 29-5 cannot be included in a bright image.

Thus, the electronic parts checking apparatus 20 according to the present embodiment checks the acceptability of the bumps based on the bright images 32 of regular rings having an even thickness of the normal bumps 29-1 obtained by the above described settings. That is, the electronic parts checking apparatus 20 according to the present embodiment is not shown in the attached drawings, but includes a parts discrimination unit having a CPU, memory, etc. The memory preliminarily stores, for each type of parts, comparison data corresponding to the bright images 32 of regular rings having an even thickness of the normal bumps 29-1 as a parameter of a parts acceptability discrimination program.

According to the present embodiment, the acceptability of a BGA electronic parts (acceptability of bumps) is discriminated based on the parameter and the bright image as shown in FIGS. 5B through 5D. This process is described below further in detail.

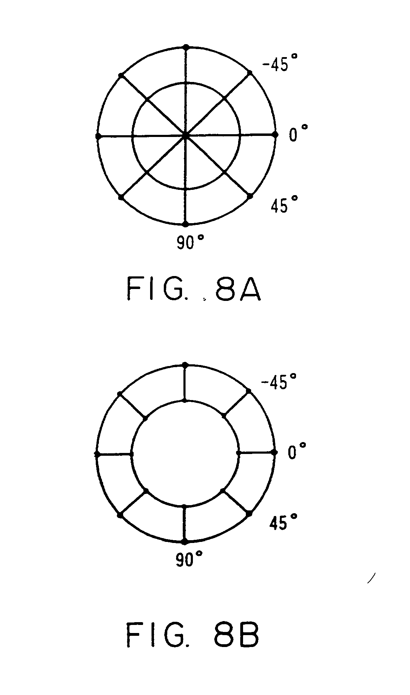

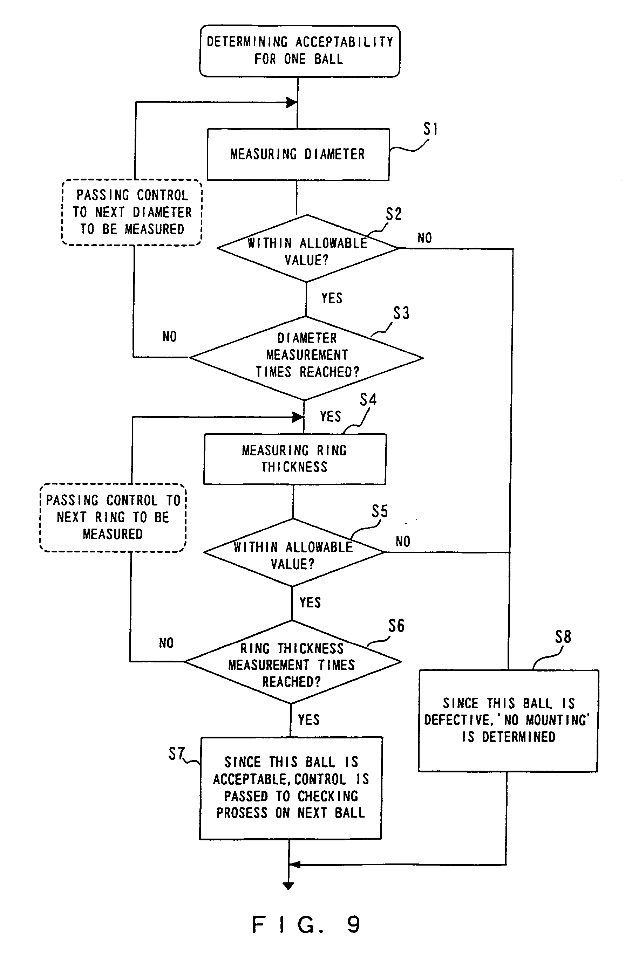

FIGS. 8A and 8B show the method of measuring a bright image in a parts acceptability discriminating process. FIG. 9 is a flowchart showing the operation of the parts acceptability discriminating process performed by a parts discrimination unit. By referring to FIGS. 8A, 8B, and 9, the process of discriminating the BGA electronic parts is described below. In this process, an acceptability discriminating process is sequentially performed for each ball (bump 29) of the BGA electronic parts 27 shown in FIGS. 4A and 4B.

In the flowchart shown in FIG. 9, when the process starts, the diameter of the shot image (bright image) is first measured (step S1). In this process, as shown in FIG. 8A, the diameter of the bright image 32 is measured in the 0° direction. The dimension data obtained by the measurement is compared with the comparison data preliminarily stored in the memory (step S2). If the result is within an allowable range (YES in S2), then it is determined whether or not the times of diameter measurements has reached a predetermined number of times, that is, whether or not the diameter has been measured four times in the 0°, 45°, 90°, and -45° directions (step S3).

If the diameter measurements has not been conducted four times as described above (NO in S3), then control is returned to step S1, and the processes in step S1 through S3 are repeated. Thus, the diameters dividing the bright image 32 to be a regular ring into 8 equal sections are sequentially measured in the 0°, 45°, 90°, and -45° directions as shown in FIG. 8A. The measurement results are compared with the comparison data preliminarily stored in the memory. If the measurement results of the above described four directions are all within the predetermined allowable range (YES in S3), then control is passed to the process of measuring the ring width (width of the ring of the bright image 32) shown in FIG. 8B.

If the comparison results with the comparison data preliminarily stored in the memory are not within the predetermined allowable range in the process of measuring the diameters in the 0°, 45°, 90°, and -45° directions (NO in S2), then it is determined that the bump 29 corresponding to the bright image 32 is a defective bump 29-2, and an error process is performed by issuing a warning, 'No mounting onto the printed substrate.' (step S8), thereby terminating the checking process on the BGA electronic parts 27.

If an abnormal condition is detected in measuring the four diameters dividing the bump 29 into eight equal sections, then the bump 29 is defective. That is, the BGA electronic parts 27 is determined to be defective, and discarded without being mounted onto the printed substrate.

On the other hand, if the measured diameters are within a predetermined allowable range (YES in S3), then control is passed to the process of measuring the width shown in FIG. 8B, and the width of the ring is measured at two points in the 0° direction selected from among the 0°, 45°, 90°, and -45° directions (step S4).

Then, it is determined whether or not the measurement result is within the allowable range preliminarily set and stored in the memory (step S5). If it is within the allowable range (YES in S5), then it is further determined whether or not the process of measuring the width of the ring has been performed predetermined times, that is, a total of four times in the 0°, 45°, 90°, and -45° directions (step S6).

If the measurement has not been conducted the total of four times at eight portions (No in S6), then control is returned to step S4, and the processes in steps S4 through S6 are repeated. Thus, the eight widths of the bright image 32 of a regular ring divided into 8 equal sections are sequentially measured in the 0°, 45°, 90°, and -45° directions as shown in FIG. 8B. The measurement results are compared with the comparison data preliminarily stored in the memory. If the measurement results of the above described four directions are all within the predetermined allowable range (YES in S6), then it is determined that the ball (bump) is acceptable (step S7), thereby terminating the checking process on the bump. Then, the process of measuring and determining the next bump is performed. That is, the processes in steps S1 through S7 are performed.

Thus, if the processes are repeated, and the measurement are completed for all the bumps 29 of the BGA electronic parts 27 without abnormal conditions, then it is determined that the BGA electronic parts 27 are normal, that is, they are acceptable, and control is passed to the process of mounting them onto a printed substrate. On the other hand, if the measurement result is not within the allowable range (NO in S5) in step S5 above, then the process in step S8 is performed, thereby terminating the checking process on the BGA electronic parts 27.

Thus, a defective condition such as uneven surfaces, lost portions, etc. can be detected by measuring the size of a bright image corresponding to the diameter of the bump of BGA electronic parts in a plurality of directions, determining whether or not the circularity of the bump is within an allowable range, and measuring the thickness of the ring of the bright image in a plurality of directions. If all the measured lengths and thicknesses are within an allowable range, then the bump is a regular hemisphere. That is, it is determined that there is a hemisphere of a normal shape. On the other hand, if any of the measured lengths or thicknesses is not within an allowable range, the bump is not normal. That is, it is determined that a defective electronic part is detected, and a warning is issued.

Since a shot image of a normal bump is displayed as a regular ring-shaped bright image having an even thickness, the entire surface of the bump can be checked using an image obtained in a single shooting process. Therefore, it is not necessary to check BGA electronic parts in more than two checking processes as in the conventional method. As a result, defective bumps, that is, defective electronic parts, can be detected correctly and efficiently, thereby avoiding the process of mistakenly mounting BGA electronic parts having defective bumps, and improving yields and economization.

## Claims

1. A bumped grid array electronic parts inspection method comprising:
lighting a bump arranged side of a bumped grid array electronic part (27) by a lighting unit (23) comprising lamps (25) aligned to form a circle around the bumped grid array electronic part and radiating light into an angular area of 10 ± 5 degrees beginning from the bump arranged side of the bumped grid array electronic part (27) ;
capturing a picture of the bump arranged side of the bumped grid array electronic part lit by said lighting unit ;
adjusting a relative position between said bumped grid array electronic part and the lighting unit so as to have the bumps of acceptable qualities on the bumped grid array electronic part respectively form bright and continuous-ring shaped images in the captured picture of the bumped grid array electronic part;
measuring the diameter of the ring shaped image of each of the bumps along lines going across the ring shaped image in four directions 45 degrees apart from each other;
determining the bumped grid array electronic part as unacceptable when a set of four direction measurement results of the diameter of any ring shaped image associated with the bumped grid array electronic part does not meet a pre-assigned set of acceptance conditions;
measuring, when the set of the four direction measurement results meets the pre-assigned set of acceptance conditions, the width of each of the ring shaped images in said all four directions ;
determining the bumped grid array electronic part as unacceptable when any of the width measurement results does not meet a pre-assigned set of acceptance conditions; and
determining the bumped grid array electronic part as acceptable when all the width measurement results meet the pre-assigned set of acceptance conditions.

2. The bumped grid array electronic parts inspection method according to claim 1, wherein said four directions 45 degrees apart from each other are directions of 0 degree, 45 degrees, 90 degree and -45 degree angles.

## Patentansprüche

1. Verfahren zum Prüfen von elektronischen Teilen, die Kontakthöcker in einer Gitteranordnung aufweisen , mit den Merkmalen:
Beleuchten eines Kontakthöckers am Rand eines elektronischen Teils (27) mit Kontakthöckern in einer Gitteranordnung mithilfe einer Beleuchtungseinheit (23), die Lampen (26) aufweist, die in einem Kreis um das elektronische Teil mit den Kontakthöckern in einer Gitteranordnung angeordnet sind, und Abstrahlen von Licht in einen Winkelbereich von 10 +/- 5 Grad ausgehend von dem am Rand des elektronischen Teils (27) mit den Kontakthöckern in einer Gitteranordnung angeordneten Kontakthöcker;
Aufnehmen eines Bildes des Kontakthöckers an dem Rand des elektronischen Teils mit Kontakthöckern in einer Gitteranordnung, der durch die Beleuchtungseinheit beleuchtet wurde;
Einstellen einer relativen Lage zwischen dem elektronischen Teil mit den Kontakthöckern in einer Gitteranordnung und der Beleuchtungseinheit, sodass die Kontakthöcker auf dem elektronischen Teil mit Kontakthöckern in einer Gitteranordnung jeweils in akzeptabler Qualität helle und kontinuierlich ringförmige Bilder in dem aufgenommenen Bild des elektronischen Teils mit den Kontakthöckern in einer Gitteranordnung bilden;
Messen des Durchmessers des ringförmigen Bildes jedes der Kontakthöcker entlang Linien, die quer durch das ringförmige Bild in vier Richtungen verlaufen, die jeweils voneinander um 45 Grad versetzt sind;
Bestimmen des elektronischen Teils mit Kontakthöckern in einer Gitteranordnung als nicht akzeptabel, wenn ein Satz von vier Ergebnissen der Richtungsmessungen des Durchmessers eines jeden ringförmigen Bildes, das dem elektronischen Teil mit den Kontakthöckern in einer Gitteranordnung zugeordnet ist, nicht einen vorbestimmten Satz von Akzeptanzbedingungen erfüllt;
Messen der Breite jedes der ringförmigen Bilder in allen diesen vier Richtungen, wenn der Satz der Ergebnisse der vier Richtungsmessungen den vorbestimmten Satz von Akzeptanzbedingungen erfüllt;
Bestimmen des elektronischen Teils mit den Kontakthöckern in einer Gitteranordnung als nicht akzeptabel, wenn jedes der Ergebnisse der einzelnen Breitenmessungen nicht einen vorgewählten Satz von Akzeptanzbedingungen erfüllt; und
Bestimmen des elektronischen Teils mit den Kontakthöckern in einer Gitteranordnung als akzeptabel, wenn alle Ergebnisse der Breitenmessungen den vorbestimmten Satz von Akzeptanzbedingungen erfüllen.

2. Verfahren zum Prüfen von elektronischen Teilen, die Kontakthöcker in einer Gitteranordnung aufweisen, nach Anspruch 1, wobei die jeweils um 45 Grad gegeneinander versetzten vier Richtungen Richtungen mit Winkeln von 0 Grad, 45 Grad, 90 Grad und -45 Grad sind.

## Revendications

1. Procédé de contrôle pour des composants électroniques à agencement de réseau de bosses, consistant à :
- éclairer un côté garni de bosses d'un composant électronique à agencement de réseau de bosses (27) par une unité d'éclairage (23) comportant des lampes (25) alignées pour former un cercle autour du composant électronique à agencement de réseau de bosses et faire rayonner une lumière dans une surface angulaire de 10±5 degrés en commençant à partir du côté garni de bosses du composant électronique à agencement de réseau de bosses (27) ;
- capter une image du côté garni de bosses du composant électronique à agencement de réseau de bosses éclairé par ladite unité d'éclairage ;
- régler une position relative entre ledit composant électronique à agencement de réseau de bosses et l'unité d'éclairage de façon à avoir les bosses de qualité acceptable sur le composant électronique à agencement de réseau de bosses qui forment respectivement des images brillantes et configurées en anneau continu dans l'image saisie du composant électrique à agencement de réseau de bosses ;
- mesurer le diamètre de l'image configurée en anneau de chacune des bosses le long de lignes passant à travers l'image configurée en anneau dans quatre directions distantes de 45 degrés l'une de l'autre ;
- déterminer le composant électronique à agencement de réseau de bosses comme ne pouvant pas être accepté lorsqu'un ensemble de résultats de mesure dans les quatre directions du diamètre de chaque image configurée en anneau associée au composant électronique à agencement de réseau de bosses ne coïncide pas avec un ensemble prédéterminé des conditions d'acceptabilité ;
- mesurer, lorsque l'ensemble des résultats de mesures dans les quatre directions satisfait l'ensemble prédéterminé de conditions d'acceptabilité, la largeur de chacune des images configurées en anneau dans l'ensemble desdites quatre directions ;
- déterminer le composant électronique à agencement de réseau de bosses comme ne pouvant pas être accepté lorsque chacun des résultats de mesure de largeur ne satisfait pas l'ensemble prédéterminé des conditions d'acceptation ; et
- déterminer le composant électronique à agencement de réseau de bosses comme étant acceptable lorsque tous les résultats de mesure de largeur satisfont l'ensemble prédéterminé des conditions d'acceptabilité.

2. Procédé de contrôle de composants électronique de matrice à grille de bosses selon la revendication 1, dans lequel lesdites quatre directions à 45 degrés l'une de l'autre sont des directions correspondant aux angles de 0 degré, 45 degrés, 90 degrés et - 45 degrés.
